(19) Europäisches Patentamt

European Patent Office

Office européen des brevets

(11) **EP 1 613 138 A1**

(12) **EUROPÄISCHE PATENTANMELDUNG**

(43) Veröffentlichungstag:
**04.01.2006 Patentblatt 2006/01**

(51) Int Cl.:
*H05K 13/04* *(2006.01)* *B05C 11/10* *(2006.01)*
*H01L 21/00* *(2006.01)*

(21) Anmeldenummer: 04103089.1

(22) Anmeldetag: **30.06.2004**

(84) Benannte Vertragsstaaten:
**AT BE BG CH CY CZ DE DK EE ES FI FR GB GR HU IE IT LI LU MC NL PL PT RO SE SI SK TR**
Benannte Erstreckungsstaaten:
**AL HR LT LV MK**

(71) Anmelder: **Unaxis International Trading Ltd 6330 Cham (CH)**

(72) Erfinder:
• **Scholze, Stephan**
  **8006, Zuerich (CH)**
• **Hartmann, Dominik**
  **6340 Baar (CH)**

(74) Vertreter: **Falk, Urs et al**
  **Patentanwaltsbüro Dr. Urs Falk,**
  **Eichholzweg 9A**
  **6312 Steinhausen (CH)**

(54) **Vorrichtung zum Auftragen von Klebstoff auf ein Substrat**

(57) Eine Vorrichtung zum Auftragen von Klebstoff auf ein Substrat (2) umfasst einen Schreibkopf (4) mit einer Schreibdüse (5) und eine Kamera (11). Der Schreibkopf (4) ist in zwei horizontalen Richtungen beweglich, damit er ein Klebstoffmuster auf das Substrat (2) schreiben kann. Die als z-Höhe bezeichnete Position des Schreibkopfs (4) wird mittels eines Positionsmess- und Regelkreises (6) sehr genau geregelt, damit die Spitze der Schreibdüse (5) in einem vorbestimmten Abstand $\Delta z_0$ über das Substrat (2) geführt werden kann. Erfindungsgemäss wird die Vorrichtung mit einem Triangulationsmesssystem, mit dessen Hilfe die z-Höhe des Substrats (2) bestimmt wird, und mit einer Kalibrierungsvorrichtung (15) für die Bestimmung der Beziehung zwischen der z-Position des Schreibkopfs (4) und der z-Höhe des Substrats (2) ausgerüstet.

Fig. 1

**EP 1 613 138 A1**

**Beschreibung**

Die Erfindung betrifft eine Vorrichtung zum Auftragen von Klebstoff auf ein Substrat der im Oberbegriff des Anspruchs 1 genannten Art, sowie ein Verfahren zum Auftragen von Klebstoff auf ein Substrat.

Bei der Montage von Halbleiterchips werden sehr häufig Klebstoffe auf Epoxy-Basis verwendet, um den Halbleiterchip auf einem Substrat zu befestigen. Der Klebstoff muss so auf das Substrat aufgetragen werden, dass beim nachfolgenden Aufsetzen des Halbleiterchips eine möglichst gleichmässig über die ganze Chipfläche verteilte, von Lufteinschlüssen freie Klebstoffschicht entsteht. Im Idealfall erteckt sich die Klebstoffschicht seitlich bis über die Kanten des Halbleiterchips hinaus und umschliesst auch die Ecken des Halbleiterchips vollständig. Zudem darf kein Klebstoff auf die Oberfläche des Halbleiterchips mit den elektronischen Schaltkreisen gelangen. Um dies zu erreichen, kommen je nach Chipformat, Klebstoffsorte und weiteren Parametern verschiedene "figürliche" Auftragsmuster zur Anwendung, die vom einfachen Diagonalenkreuz bis zu mehrfach verzweigten Strichfiguren reichen.

Um solche figürliche Muster aufzutragen, sind grundsätzlich zwei Verfahren bekannt. Beim ersten, z.B. aus der europäischen Patentanmeldung EP 928 637 bekannten Verfahren erfolgt das Auftragen mittels einer mit einer Vielzahl von Austrittsöffnungen ausgebildeten Düse. Die Austrittsöffnungen der Düse befinden sich auf einer vorbestimmten Höhe über dem Substrat. Die benötigte Klebstoffmenge wird mittels eines Druckpulses ausgestossen. Dabei hängt die Form der ausgestossenen Klebstoffmenge vom Abstand zwischen der Düse und dem Substrat ab. Beim zweiten, z.B. aus der europäischen Patentanmeldung EP 901 155 bekannten Verfahren erfolgt das Auftragen mittels einer an einem Schreibkopf befestigten Einzeldüse. Der Schreibkopf wird in einer entsprechend dem gewünschten Klebstoffmuster programmierten Bewegung über das Substrat geführt und "zeichnet" dabei das Klebstoffmuster.

Das Auftragen des Klebstoffes auf das Substrat ist ein heikler Prozess. Ein wichtiger Parameter, der mit grosser Genauigkeit einzuhalten ist, ist der Abstand der Düse vom Substrat. Bevor der Produktionsprozess beginnt, muss die Höhe der Substratplätze gemessen werden. Dies erfolgt, indem die in der Höhe verstellbare Düse abgesenkt wird, bis sie den Substratplatz berührt. Diese Berührung wird detektiert und als Substrathöhe gespeichert. Diese Messmethode hat mehrere Nachteile:

- Die Düse hinterlässt meistens Klebstoff auf dem Substrat.
- Die Messung ist langsam, weil die Berührung mechanisch detektiert wird.
- Bei Anwendungen, bei denen mehrere Halbleiterchips übereinander montiert werden (sogenannte "stacked dies" Anwendungen), muss jeweils die Höhe der Oberfläche des Halbleiterchips bestimmt werden, auf dem der nächste Halbleiterchip zu platzieren ist. Hier besteht ein erhebliches Risiko, dass der Halbleiterchip bei der Messung beschädigt wird.

Der Erfmdung liegt die Aufgabe zugrunde, eine Messmethode zu entwickeln, die diese genannten Nachteile nicht mehr aufweist.

Die genannte Aufgabe wird erfindungsgemäss gelöst durch die Merkmale der Ansprüche 1 und 2.

Eine Vorrichtung zum Auftragen von Klebstoff auf ein Substrat umfasst einen Schreibkopf mit einer Schreibdüse und eine Kamera. Der Schreibkopf ist in zwei horizontalen Richtungen beweglich, damit er ein Klebstoffmuster auf das Substrat schreiben kann. Die als z-Höhe bezeichnete Position des Schreibkopfs wird mittels eines Positionsmess- und Regelkreises sehr genau geregelt, damit die Spitze der Schreibdüse in einem vorbestimmten Abstand $\Delta z_0$ über das Substrat geführt werden kann. Damit das Klebstoffmuster an der richtigen Stelle auf dem Substrat aufgetragen wird, wird die Lage des Substrats vor dem Auftragen des Klebstoffes von einer Kamera vermessen. Erfindungsgemäss wird die Vorrichtung mit einem Triangulationsmesssystem, mit dessen Hilfe die z-Höhe des Substrats bestimmt wird, und mit einer Kalibrierungsvorrichtung für die Bestimmung der Beziehung zwischen der z-Position des Schreibkopfs und der z-Höhe des Substrats ausgerüstet. Das Triangulationsmesssystem umfasst einen Laser, der einen Laserstrahl aussendet, der mit der Horizontalen einen vorbestimmten Winkel einschliesst, und benützt die ohnehin vorhandene Kamera für die Bestimmung der Lage des Auftreffpunkts des Laserstrahls auf dem Substrat. Die Kalibrierungsvorrichtung enthält eine auslenkbare Fläche. In einem Kalibrierungsvorgang werden die Lage des Auftreffpunkts des Laserstrahls auf der auslenkbaren Fläche bezüglich der optischen Achse der Kamera und die z-Höhe des Schreibkopfs bestimmt, bei der die Schreibdüse des Schreibkopfs die auslenkbare Fläche berührt. Im Produktionsbetrieb wird die Lage des Auftreffpunkts des Laserstrahls auf dem Substrat und daraus die z-Höhe des Substrats bestimmt und die z-Höhe des Schreibkopfs entsprechend der gemessenen z-Höhe des Substrats eingestellt.

Das Auftragen von Klebstoff auf das Substrat erfolgt also so, dass in einer Lernphase die Lage $w_R$ des Auftreffpunkts des Laserstrahls auf der auslenkbaren Fläche bezüglich der optischen Achse der Kamera bestimmt wird und dass anschliessend der Schreibkopf abgesenkt wird, bis die Schreibdüse die auslenkbare Fläche berührt und auslenkt. Dabei wird die z-Höhe des Schreibkopfs zu dem Zeitpunkt bestimmt, an dem die Schreibdüse die auslenkbare Fläche berührt. In der Produktionsphase wird die Lage $w_1$ des Auftreffpunkts des Laserstrahls auf dem Substrat bezüglich der optischen Achse der Kamera bestimmt und aus den Werten $w_1$ und $w_R$, sowie gegebenenfalls weiterer Positionsdaten des Lasers und/oder der Kamera, die z-Höhe $H_1$ des Substrats berechnet. Der Schreibkopf nimmt beim Auftragen des Klebstoffes die z-Höhe $z = H_1 + \Delta z_0$ ein, wobei die Grösse $\Delta z_0$ einen vorbestimmten Wert aufweist. Die Grösse $\Delta z_0$ beträgt typischerweise 10 Mikrometer.

Die Erfindung wird nachfolgend anhand von Ausführungsbeispielen und anhand der Zeichnung näher erläutert.

Es zeigen:

Fig. 1     Vorrichtung zum Auftragen von Klebstoff auf ein Substrat,

Fig. 2     eine Darstellung von geometrischen Verhältnissen,

Fig. 3     einen Schlitten, auf dem eine Kamera und ein Laser befestigt sind,

Fig. 4     ein Antriebssystem für einen Schreibkopf, und

Fig. 5     eine Kalibrierungsvorrichtung.

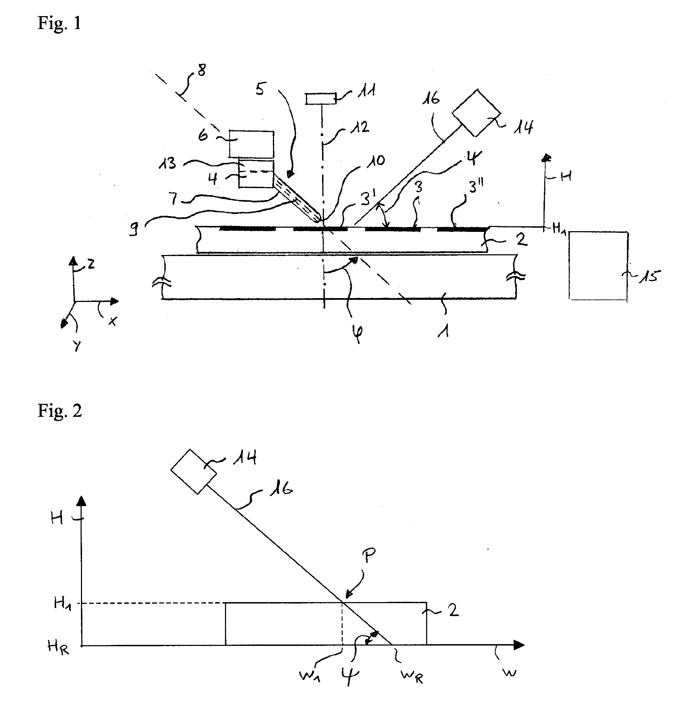

Die Fig. 1 zeigt in seitlicher Ansicht eine Vorrichtung zum Auftragen von Klebstoff auf ein Substrat 2, die als Dispensstation in einer als Die Bonder bekannten Halbleiter-Montageeinrichtung eingesetzt ist. Mit x, y und z sind die Achsen eines kartesischen Koordinatensystems bezeichnet, wobei die beiden Achsen x und y in einer horizontalen Ebene verlaufen. Die x-Achse bezeichnet zudem die Transportrichtung einer Transportvorrichtung 1 für den Transport der Substrate 2. Jedes Substrat 2 weist eine vorbestimmte Anzahl von Chip-Montageflächen 3, 3' auf, die in regelmässigen Abständen angeordnet sind. Die Transportvorrichtung 1 ermöglicht, fakultativ, eine Verschiebung des Substrats 2 entlang der y-Achse. Die Transportvorrichtung 1 transportiert das Substrat 2 in der Transportrichtung x zunächst zur Dispensstation, wo Klebstoff auf die bereitgestellte Chip-Montagefläche 3' aufgetragen wird, und dann zu einer Bondstation, wo ein Halbleiterchip auf der Chip-Montagefläche platziert wird. Eine solche Transportvorrichtung 1 ist beispielsweise aus der EP 330 831 bekannt. Die Dispensstation umfasst einen Schreibkopf 4 mit einer Schreibdüse 5. Ein Antriebssystem ermöglicht die Bewegung des Schreibkopfs 4 in den drei Richtungen x, y und z. Ein geeignetes Antriebssystem, das auch einen Positionsmess- und Regelkreis 6 für die präzise Regelung der z-Höhe des Schreibkopfs 4 aufweist, ist beispielsweise aus der EP 901 155 bekannt. Die Schreibdüse 5 ist vorzugsweise auswechselbar am Schreibkopf 4 befestigt. Die Schreibdüse 5 weist eine längliche Form auf: Sie besteht aus einem länglichen Körper 7 mit einer entlang der Längsachse 8 des Körpers 7 verlaufenden Bohrung 9, die in eine einzige Austrittsöffnung 10 mündet. Die Halbleiter-Montageeinrichtung umfasst weiter eine Kamera 11 für die Vermessung der Lage und Orientierung der zum Auftragen von Klebstoff bereitgestellten Chip-Montagefläche 3'. Die optische Achse 12 der Kamera 11 verläuft parallel zur z-Achse. Die optische Achse 12 der Kamera 11 verläuft somit senkrecht zur Chip-Montagefläche 3'. Bei korrekter Fokussierung der Kamera 11 liegt die ganze Chip-Montagefläche 3' in der Schärfenebene der Kamera 11. Die Schreibdüse 5 ist so am Schreibkopf 4 angeordnet, dass ihre Längsachse 8 mit der z-Achse bzw. der optischen Achse 12 der Kamera 11 einen vorbestimmten Winkel $\varphi$ einschliesst. Der Winkel $\varphi$ liegt typischerweise im Bereich von 30° bis 60°. Somit befindet sich nur die Spitze der Schreibdüse 5 im Bereich der optischen Achse 12 der Kamera 11. Ein Teil der Schreibdüse 5 befindet sich nach wie vor im Blickfeld der Kamera 11. Die Länge der Schreibdüse 5 ist so bemessen, dass sich der Schreibkopf 4 ausserhalb des Blickfeldes der Kamera 11 befindet oder höchstens einen Randbereich des Blickfeldes der Kamera 11 bzw. des von der Kamera 11 gelieferten Bildes abdeckt. Die Schreibdüse 5 ist über eine Pumpe 13 mit einem Klebstoffreservoir verbunden. Die Pumpe 13 kann wie im gezeigten Beispiel im Schreibkopf 5 integriert sein oder stationär auf der Halbleiter-Montageeinrichtung angeordnet sein. Die Pumpe 13 steuert das Ausscheiden des Klebstoffs aus der Schreibdüse 5.

Die Dispensstation ist erfindungsgemäss ausgerüstet mit einem Triangulationsmesssystem mit einem Laser 14 und mit einer Kalibrierungsvorrichtung 15 für die Bestimmung der Beziehung zwischen der z-Höhe des Schreibkopfs 4 und dem Triangulationsmesssystem. Der Laser 14 sendet einen auf das Substrat 2 gerichteten Laserstrahl 16 aus, der unter einem bezüglich der Horizontalen vorbestimmten Winkel $\psi$ schräg auf das Substrat 2 auftrifft. Der Winkel $\psi$ liegt vorzugsweise im Bereich von 30° bis 60°. Er beträgt typischerweise etwa 45°. Wenn sich die Höhe $H_1$ der Oberfläche des Substrats 2 ändert, dann ändert sich auch die Position des Auftreffpunkts P des Laserstrahls 16 auf dem Substrat 2. Die Position des Auftreffpunkts P wird mit der Kamera 11 ermittelt und aus der Positionsänderung $\Delta w$ die Höhe $H_1$ der Oberfläche des Substrats 2 berechnet. Wie aus der Fig. 2 ersichtlich ist, ergibt sich die Höhe $H_1$ der Oberfläche des Substrats 2 zu:

$$H_1 = H_R + \Delta w * \tan(\psi) \qquad\qquad (1)$$

Dabei bezeichnen:

$H_R$ eine Referenzhöhe,

w: eine Koordinatenachse, die defmiert ist als die Richtung des Laserstrahls 16 in der xy-Ebene, d.h. die Projektion des Laserstrahls 16 auf die xy-Ebene,

$w_R$: die Position des Auftreffpunkts P des Laserstrahls 16, wenn sich die Oberfläche des Substrats 2 auf der Referenzhöhe $H_R$ befmdet,

$w_1$: die Position des Auftreffpunkts P des Laserstrahls 16, wenn sich die Oberfläche des Substrats 2 auf der zu messenden Höhe $H_1$ befindet, und

$\Delta w = w_1 - w_R$.

Aus dem von der Kamera gelieferten Bild erhält man die Positionen $p_R$ und $p_1$ in Pixelkoordinaten. Durch eine Eichmessung ist daher ein Umrechnungsfaktor k zu bestimmen, damit die in Pixelkoordinaten der Kamera 11 berechnete Differenz $\Delta p = p_1 - p_R$ in die absolute Wegdifferenz $\Delta w$ umgerechnet werden kann:

$$\Delta w = k * \Delta p. \tag{2}$$

Wenn sowohl die Kamera 11 als auch der Laser 14 ortsfest angeordnet sind, dann hängt die Lage des Auftreffpunkts P nur von der zu messenden Höhe $H_1$ ab und die Höhe $H_1$ kann gemäss den Gleichungen (1) und (2) mit den von der Kamera 11 gelieferten Pixelkoordinaten berechnet werden. Es ist aber in vielen Fällen unumgänglich, dass der Laser 14 und/oder die Kamera 11 in x- und/oder y-Richtung verschiebbar sind. In diesen Fällen ist es vorteilhaft, ein globales Koordinatensystem (u, v) zu verwenden und die geregelten Positionen des Lasers 14 und der Kamera 11 sowie die gemessenen Positionen $w_1$ und $w_R$ des Auftreffpunkts P des Laserstrahls 16 jeweils in globale Koordinaten $(u_1, v_1)$ bzw. $(u_R, v_R)$ umzurechnen und daraus die Höhe $H_1$ zu berechnen.

Im folgenden werden bevorzugte Möglichkeiten erläutert, wie der Laser 14 in die Dispensstation einzubauen ist.

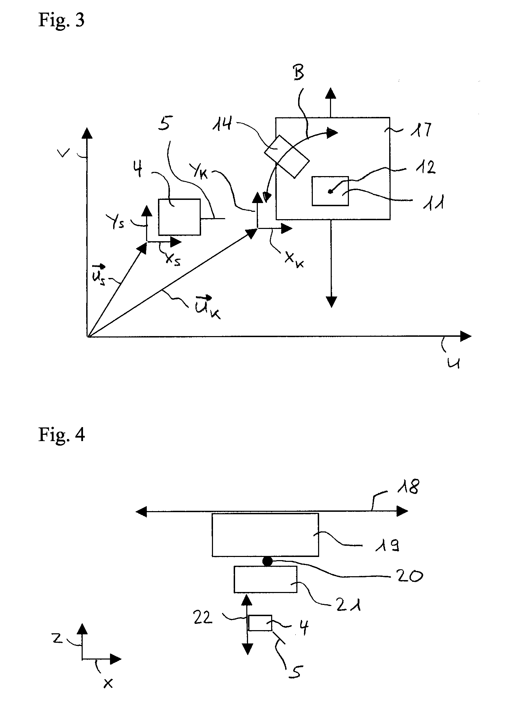

Bei einer Dispensstation, bei der die Kamera 11 in y-Richtung verschiebbar ist, ist der Laser 14 bevorzugt so angeordnet, dass er zusammen mit der Kamera 11 in y-Richtung verschiebbar ist. Die Fig. 3 zeigt in Aufsicht ein solches Beispiel. Die Kamera 11 und der Laser 14 sind auf einem Schlitten 17 angeordnet, der in der y-Richtung verschiebbar ist. Vorzugsweise ist die Lage des Lasers 14 auf dem Schlitten 17 innerhalb eines vorbestimmten Bereichs B verstellbar, so dass die Richtung w bei Bedarf geändert werden kann. Bei diesem Beispiel sind zudem ein erstes lokales Koordinatensystem $(x_S, y_S)$ des Schreibkopfs 4, ein zweites lokales Koordinatensystem $(x_K, y_K)$ der Kamera 11 und das globale Koordinatensystem (u, v) dargestellt. Ein Positionsmess- und Regelsystem des Schreibkopfs 4 regelt die Lage des Schreibkopfs 4 unter Bezug auf die lokalen Koordinaten $(x_S, y_S)$, ein Positionsmess- und Regelsystem der Kamera 11 regelt die Lage der optischen Achse 12 der Kamera 11 unter Bezug auf die lokalen Koordinaten $(x_K, y_K)$. Die globalen Koordinaten des Schreibkopfs 4 sind gegeben durch

$$(u_S, v_S) = (u_{S0}, v_{S0}) + (x_S, y_S),$$

die globalen Koordinaten der optischen Achse 12 der Kamera 11 sind gegeben durch

$$(u_K, v_K) = (u_{K0}, v_{K0}) + (x_K, y_K).$$

Die Fig. 4 zeigt ein Antriebssystem für die Bewegung des Schreibkopfs 4 entlang den drei Koordinatenachsen x, y und z. Das Antriebssystem umfasst eine erste, ortsfest angeordnete Führung 18, auf der ein erster, in x-Richtung beweglicher Schlitten 19 gelagert ist, eine zweite, auf dem ersten Schlitten 19 angeordnete Führung 20, auf der ein zweiter, in y-Richtung beweglicher Schlitten 21 gelagert ist, und eine dritte, auf dem zweiten Schlitten 21 angeordnete Führung 22, auf der der Schreibkopf 4 gelagert ist, sowie drei Motoren für den Antrieb des ersten Schlittens 19 in x-Richtung, den Antrieb des zweiten Schlittens 21 in y-Richtung und den Antrieb des Schreibkopfs 4 in z-Richtung.

Falls der Laser 14 weder ortsfest angeordnet, noch gemeinsam mit der Kamera 11 verschiebbar angeordnet ist, dann besteht eine erste Möglichkeit darin, den Laser 14 am Schreibkopf 4 zu befestigen, so dass der Laser 14 alle Bewegungen des Schreibkopfs 4 in x, y und z-Richtung mitmacht. Eine zweite Möglichkeit besteht darin, den Laser 14 am zweiten Schlitten 21 zu befestigen, so dass der Laser 14 nur Bewegungen des Schreibkopfs 4 in x und y-Richtung, nicht aber in z-Richtung mitmacht. Diese beiden Möglichkeiten eignen sich insbesondere dann, wenn die Kamera 11 ortsfest angeordnet ist.

Bei allen diesen drei Ausführungsmöglichkeiten ist der Laser 14 bevorzugt so befestigt, dass er um die Achse des Laserstrahls 16 drehbar ist, damit die Polarisationsrichtung des Laserlichts bezüglich des Substrats 2 geändert werden kann, und dass die Richtung w verstellbar ist, damit allfällige Beugungseffekte des Laserlichts auf dem Substrat 2 minimiert werden können. Insbesondere bei Halbleiterchips, die Speicherelemente mit einer Vielzahl von parallel zu den Kanten des Halbleiterchips verlaufenden Strukturen aufweisen, kann es vorteilhaft sein, wenn die Richtung w entlang einer Diagonale des Halbleiterchips verläuft.

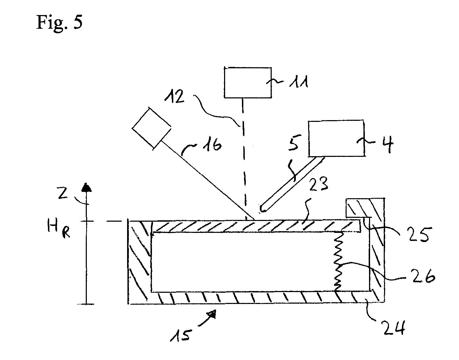

Die z-Höhe der Schreibdüse 5 wird mittels eines an sich bekannten Positionsmess- und Regelkreises gesteuert, der die Regelung der z-Höhe des Schreibkopfs 4 mit einer im Mikrometerbereich liegenden Genauigkeit ermöglicht, die für das Auftragen von Klebstoff auf das Substrat 2 ausreicht. Damit die z-Höhe der Spitze der am Schreibkopf 4 befestigten Schreibdüse 5 relativ zur Oberfläche des Substrats 2 eingestellt werden kann, muss noch die Beziehung zwischen der z-Position des Schreibkopfs 4 und der Referenzhöhe $H_R$ bestimmt werden. Diese Bestimmung erfolgt mittels der Vorrichtung 15 für die Bestimmung der Beziehung zwischen der z-Position des Schreibkopfs 4 und dem Triangulationsmesssystem. Die Kalibrierungsvorrichtung 15 enthält eine Fläche, die bei Berührung mit der Schreibdüse 5 ausgelenkt wird. Als auslenkbare Fläche dient beispielsweise die Oberfläche eines Biegebalkens 23, wie dies anhand der Fig. 5 näher erläutert wird. Die Vorrichtung 15 enthält eine Basis 24 mit einem Anschlag 25, den Biegebalken 23 und eine Feder 26. Ein Ende des Biegebalkens 23 ist an der Basis 24 gelagert. Die Feder 26 drückt das andere Ende des Biegebalkens 23 gegen den Anschlag 25 der Basis 24. Diese Lage des Biegebalkens 23 definiert die Referenzhöhe $H_R$. Die Lage des Auftreffpunkts P des Laserstrahls 16 auf dem Biegebalken 23 wird mittels der Kamera 11 überwacht. Nun wird der Schreibkopf 4 in z-Richtung abgesenkt. Sobald die Spitze der Schreibdüse 5 den Biegebalken 23 berührt und entgegen der Kraft der Feder 26 auslenkt, verschiebt sich die Lage des Auftreffpunkts P auf dem Biegebalken 23. Es wird nun die z-Höhe $z_S$ des Schreibkopfs 4 an dem Zeitpunkt bestimmt, an dem die Kamera 11 den Beginn der Verschiebung der Lage des Auftreffpunkts P detektierte. Die z-Höhe $z_S$ ist gleich der Referenzhöhe $H_R$: $z_S = H_R$. Zudem werden die Koordinaten $(x_K, y_K)$ der optischen Achse 12 der Kamera 11 und die Position $(x_P, y_P)$ des Auftreffpunkts P des Laserstrahls 16 bezüglich der von den beiden Bildachsen der Kamera 11 aufgespannten Achsen bestimmt.

Das Auftragen von Klebstoff erfolgt im Produktionsbetrieb gemäss den folgenden Schritten:

- Bestimmen der Höhe $H_1$ der Oberfläche des Substrats 2, auf der der Klebstoff aufzutragen ist,
- Mit dem Schreibkopf 4 Anfahren der Höhe $z = H_1 + \Delta z_0$, wobei $\Delta z_0$ dem Abstand entspricht, den die Spitze der Schreibdüse 5 zur Oberfläche des Substrats 2 einnehmen soll, und
- Auftragen des Klebstoffs.

Wenn die Fläche, auf der der Klebstoff aufzutragen ist, eine gewisse Grösse überschreitet, dann ist es unter Umständen vorteilhaft, die Höhe der Fläche an allen vier Ecken zu bestimmen und diese Erkenntnisse bei der Steuerung der z-Höhe des Schreibkopfs 4 zu berücksichtigen.

Wenn der Schreibkopf 4 in x-Richtung und in y-Richtung bewegt wird, dann ändert sich in der Regel der Abstand des Schreibkopfs 4 von der Prozessauflage, da eine rein mechanische Planarität der Führungen 18 und 20 zur Prozessfläche nur mit grossem Aufwand erreichbar ist. Aus diesem Grund wird die Abweichung $\Delta z(x, y)$ der z-Höhe des Schreibkopfs 4 in Funktion des Ortes $(x, y)$ in einem Kalibriervorgang ermittelt. Wenn der Laser 14 am zweiten Schlitten des Antriebssystems für den Schreibkopf 4 befestigt ist, so dass der Laser 14 nur Bewegungen des Schreibkopfs 4 in x und y-Richtung, nicht aber in z-Richtung mitmacht, dann kann die Funktion $\Delta z(x, y)$ beispielsweise mit dem Laser 14 bestimmt werden. Die Funktion $\Delta z(x, y)$ wird dann im Produktionsbetrieb benützt, um die systembedingten Abweichungen zu eliminieren.

Die erfindungsgemässe Vorrichtung zum Auftragen von Klebstoff auf ein Substrat ist nicht beschränkt auf das Gebiet der Montage von Halbleiterchips. Mit der gleichen Vorrichtung können auch Substrate für andere Bauteile, beispielsweise optische Bauteile, mikromechanische Bauteile, passive elektrische Bauteile wie Widerstände und Kondensatoren, etc. mit Klebstoff beschichtet werden.

**Patentansprüche**

1. Vorrichtung zum Auftragen von Klebstoff auf ein Substrat (2), mit einem Schreibkopf (4) mit einer Schreibdüse (5) und mit einer Kamera (11), wobei eine als z-Höhe bezeichnete Position des Schreibkopfs (4) mittels eines Positionsmess- und Regelkreises (6) geregelt wird, **gekennzeichnet durch** einen Laser (14), der einen Laserstrahl (16) aussendet, der mit der Horizontalen einen vorbestimmten Winkel $\psi$ einschliesst, und **durch** eine Kalibrierungsvorrichtung (15) mit einer auslenkbaren Fläche, wobei in einem Kalibrierungsvorgang die Lage des Auftreffpunkts des Laserstrahls (16) auf der auslenkbaren Fläche bezüglich der optischen Achse (12) der Kamera (11) und die z-Höhe des Schreibkopfs (4) bestimmbar ist, bei der die Schreibdüse (5) des Schreibkopfs (4) die auslenkbare Fläche berührt.

2. Verfahren zum Auftragen von Klebstoff auf ein Substrat (2), wobei eine als z-Höhe bezeichnete Position eines Schreibkopfs (4) mit einer Schreibdüse (5) mittels eines Positionsmess- und Regelkreises (6) geregelt wird, **dadurch gekennzeichnet, dass** in einer Lernphase die Lage $w_R$ des Auftreffpunkts eines Laserstrahls (16) auf einer auslenkbaren Fläche bezüglich der optischen Achse (12) einer Kamera (11) bestimmt wird und dass der Schreibkopf (4) abgesenkt wird, bis die Schreibdüse (5) die auslenkbare Fläche berührt und auslenkt, wobei die z-Höhe des Schreibkopfs (4) zu dem Zeitpunkt bestimmt wird, an dem die Schreibdüse (5) die auslenkbare Fläche berührt hat, und dass in einer Produktionsphase die Lage $w_1$ des Auftreffpunkts des Laserstrahls (16) auf dem Substrat (2) bezüglich der optischen Achse (12) der Kamera (11) bestimmt wird, dass aus den Werten $w_1$ und $W_R$ die z-Höhe $H_1$ des Substrats (2) berechnet wird und dass der Schreibkopf (4) beim Auftragen des Klebstoffes die z-Höhe $z = H_1 + \Delta z_0$ einnimmt, wobei die Grösse $\Delta z_0$ einen vorbestimmten Wert aufweist.

Fig. 1

Fig. 2

Fig. 3

Fig. 4

Fig. 5

**Europäisches Patentamt**

**EUROPÄISCHER RECHERCHENBERICHT**

Nummer der Anmeldung

EP 04 10 3089

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | EP 1 432 013 A (ESEC TRADING S A) 23. Juni 2004 (2004-06-23) * das ganze Dokument * ----- | 1,2 | H05K13/04 B05C11/10 H01L21/00 |
| A | DE 39 41 318 A (JUKI KK) 21. Juni 1990 (1990-06-21) * Spalte 4, Zeile 45 - Spalte 8, Zeile 41; Abbildungen 1,2 * ----- | 1,2 | |
| A | US 6 671 576 B1 (CHEN CHIH-KUN) 30. Dezember 2003 (2003-12-30) * Spalte 2, Zeile 31 - Spalte 3, Zeile 67; Abbildung 1 * ----- | 1,2 | |

RECHERCHIERTE SACHGEBIETE (Int.Cl.7)

H05K
B05C
H01L

Der vorliegende Recherchenbericht wurde für alle Patentansprüche erstellt

| Recherchenort | Abschlußdatum der Recherche | Prüfer |
|---|---|---|
| München | 21. Dezember 2004 | Jelercic, D |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
.............................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 04 10 3089

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

21-12-2004

| Im Recherchenbericht angeführtes Patentdokument | | Datum der Veröffentlichung | Mitglied(er) der Patentfamilie | | Datum der Veröffentlichung |
|---|---|---|---|---|---|
| EP 1432013 | A | 23-06-2004 | EP | 1432013 A1 | 23-06-2004 |
| DE 3941318 | A | 21-06-1990 | JP | 2005992 C | 11-01-1996 |
| | | | JP | 2162789 A | 22-06-1990 |
| | | | JP | 7037895 B | 26-04-1995 |
| | | | DE | 3941318 A1 | 21-06-1990 |
| | | | FR | 2640812 A1 | 22-06-1990 |
| US 6671576 | B1 | 30-12-2003 | TW | 528709 B | 21-04-2003 |

Für nähere Einzelheiten zu diesem Anhang : siehe Amtsblatt des Europäischen Patentamts, Nr.12/82

EPO FORM P0461